# EUROPEAN PATENT APPLICATION

(11) **EP 4 542 635 A1**
(43) Date of publication of application: **23.04.2025**
(21) Application number: 24204732.2
(22) Date of filing: 04.10.2024
(51) Int. Cl.: H01L 21/677

(54) **TRANSPORT APPARATUS**

(30) Priority: 06.10.2023 JP 2023174138
(71) Applicant: Daifuku Co., Ltd., Osaka-shi, Osaka 555-0012 (JP)
(72) Inventor: TOMIDA, Daichi, Shiga, 529-1692 (JP)
(74) Representative: Grosse, Felix Christopher

(57) **Abstract**

A transport apparatus 1 for transporting a container 8 having an opening 86 includes: a holding device 30 configured to hold a container 8; and a restricting device 60 configured to restrict a target object 9 from exiting the container 8 through the opening 86 while the container 8 is held by the holding device 30. The restricting device 60 includes at least one closing member 61 configured to move to a closed position in which the closing member 61 overlaps the opening 86 and an open position in which the closing member 61 does not overlap the opening 86. The closing member 61 is configured to move in conjunction with a movement of the holding members 32 included in the holding device 30.

## Description

The present invention relates to a transport apparatus.

For example, in semiconductor manufacturing plants and the like, transport apparatuses are used to transport containers that store objects to be stored, such as wafers and reticles. There are various types of containers, and in some cases, containers may be used that have an opening on their side surface through which objects to be stored are inserted and removed. One example of a transport apparatus for transporting such containers that have an opening for insertion and removal on their side surface is disclosed in JP 2018 39 656 A.

A transport apparatus (transport apparatus 3) according to JP 2018 39 656 A includes a restricting device (fall prevention member 35S) that restricts a stored object (semiconductor tray T) from falling out of an opening (opening Wa) when a container (container W) is transported. This restricting device is constituted by a pair of rod-shaped members that can slide in the width direction of the opening by means of a cylinder that expands and contracts, and after a holding device (a grip 31S) holds the container, the rod-shaped members move toward each other to prevent the stored objects from falling out of the opening (paragraph 0033 of JP 2018 39 656 A).

The transport apparatus according to JP 2018 39 656 A is configured so that the restricting device operates after the holding device holds the container, and therefore each of the devices requires an independent drive mechanism, which leaves room for improvement in terms of miniaturization and simplification of the transport apparatus.

Therefore, it is desirable to realize a transport apparatus that can prevent the stored objects from flying out of the opening of the container during transport, while minimizing and simplifying the apparatus.

A transport apparatus according to the present invention is a transport apparatus for transporting a container having an opening in a side surface thereof through which a target object is removed or inserted, the transport apparatus including: a holding device including a plurality of holding members and a drive device configured to move the plurality of holding members to a holding position for holding the container and a holding release position for releasing the container; and a restricting device configured to restrict the target object from exiting the container through the opening while the container is held by the holding device, the restricting device including at least one closing member movable to a closed position, in which the at least one closing member overlaps the opening as viewed in a removal-insertion direction in which the target object is inserted into and removed from the container through the opening, and an open position, in which the at least one closing member does not overlap the opening as viewed in the removal-insertion direction, the at least one closing member being movable in conjunction with the movement of the holding members such that the at least one closing member moves to the closed position in accordance with the holding members moving to the holding position, and the at least one closing member moves to the open position in accordance with the holding members moving to the holding release position.

With this configuration, it is possible to prevent the target object from exiting the container through the opening by setting the closing member of the restricting device to the closed position during transport. In addition, the movement of the closing member to the closed position and the open position is linked with the movement of the holding members to the holding position and the holding release position, and therefore there is no need to provide a dedicated drive mechanism for changing the position of the closing member. Therefore, it is possible to downsize and simplify the apparatus.

Further features and advantages of the techniques disclosed herein will become more apparent from the following description of exemplary and non-limiting embodiments, which is made with reference to the drawings.
- FIG. 1: is a front view of a transport vehicle according to an embodiment;
- FIG. 2: is a perspective view of a container;
- FIG. 3: is a diagram showing a first position in which a holding device and a restricting device are viewed from below;
- FIG. 4: is a diagram showing a second position in which the holding device and the restricting device are viewed from below;
- FIG. 5: is a partially enlarged view of FIG. 4;
- FIG. 6: is a perspective view of a transport apparatus;
- FIG. 7: is a side view of the transport apparatus; and
- FIG. 8: is a partially enlarged view of a restricting device according to another embodiment.

Embodiments of the present invention will now be described with reference to the accompanying drawings, wherein like reference numerals designate corresponding or identical elements throughout the various drawings.

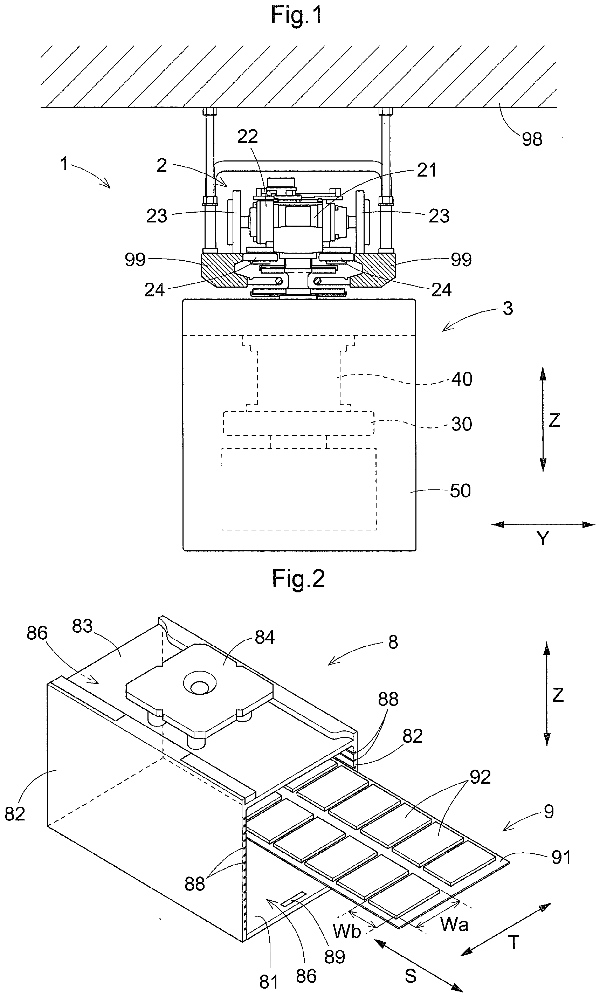

A transport apparatus 1 according to the present embodiment is used to transfer a container 8 in, for example, a semiconductor manufacturing plant. As shown in FIG. 1, the transport apparatus 1 includes a travel unit 2 that travels along a movement path, and a transfer mechanism 3 coupled to the travel unit 2. In the present embodiment, the movement path of the transport apparatus 1 is physically formed as rails 99 suspended and supported from a ceiling 98. That is, the transport apparatus 1 according to the present embodiment is an overhead transport vehicle that moves along the rails 99 formed along the ceiling 98.

The travel unit 2 travels along the pair of rails 99. The travel unit 2 includes a body 21, a travel drive device 22, wheels 23, and guide wheels 24. The body 21 supports the travel drive device 22, the wheels 23, the guide wheels 24, etc. The travel drive device 22 includes an electric motor such as a servo motor, and drives at least one wheel 23. The wheels 23 roll on the upper surfaces of the rails 99. The wheels 23, which are coupled to the travel drive device 22 to be driven, function as driving wheels. The guide wheels 24 roll on the inner surfaces of the rails 99. The travel unit 2 travels on the rails 99 along the rails 99 with the guide wheels 24 in contact with and guided by the inner surfaces of the rails 99.

In the following description, a direction in which the rails 99 extend, which is a direction in which the travel unit 2 travels, is referred to as a front-rear direction X with respect to the transport apparatus 1. A direction orthogonal to the front-rear direction X and extending parallel to the direction in which the pair of rails 99 are arranged is referred to as a left-right direction Y with respect to the transport apparatus 1. A direction orthogonal to both the front-rear direction X and the left-right direction Y is referred to as an up-down direction Z. Note that each of these directions is a direction with respect to the transport apparatus 1, and the front-rear direction X and the left-right direction Y may differ depending on the position of the transport apparatus 1 along the movement path as viewed from a fixed point in the facility. The up-down direction Z coincides with the vertical direction.

The transfer mechanism 3 is disposed below the rails 99 and is coupled to the travel unit 2. The transfer mechanism 3 includes a holding device 30, a lifting and lowering device 40, and a cover member 50. The holding device 30 is a device for holding the container 8. The lifting and lowering device 40 is a device for lifting and lowering the holding device 30. The lifting and lowering device 40 lifts and lowers the holding device 30 between a raised position shown in FIG. 1 and a lowered position not shown. The cover member 50 houses the lifting and lowering device 40 and the holding device 30 in the raised position. The internal space of the cover member 50 is shielded on both sides in the front-rear direction X, and is open on at least one side (both sides in this example) in the left-right direction Y.

The transport apparatus 1 transports the container 8 to the destination as a result of, for example, the travel unit 2 traveling to the destination while the holding device 30 holds the container 8, and the lifting and lowering device 40 lowering the holding device 30 to the lowered position. The transport apparatus 1 can remove the container 8 from the point by performing the above-mentioned operations in reverse.

As shown in FIG. 2, the container 8, which is an object to be transported by the transport apparatus 1 according to the present embodiment, includes a bottom plate 81, side plates 82, and a top plate 83. The bottom plate 81 is a support plate disposed at the lower end of the container 8, and is formed in a quadrilateral shape (in this example, a rectangular shape). The side plates 82 extend upward from the outer edges of the bottom plate 81. In the present embodiment, the pair of side plates 82 extend upward from the outer edges of opposite sides (in this example, a pair of long sides) of the quadrilateral bottom plate 81. The side plates 82 are each formed in a quadrilateral shape (in this example, a rectangular shape). The top plate 83 is disposed at the upper ends of the side plates 82 and is formed in the same shape as the bottom plate 81 (in this example, a rectangular shape) and is disposed parallel to the bottom plate 81.

The bottom plate 81, the pair of side plates 82, and the top plate 83 are integrally formed, and the container 8 is formed into a quadrilateral tube shape as a whole. The container 8 has a pair of openings 86 on the sides where the pair of side plates 82 are not present. These openings 86 are openings 86 for inserting and removing a target object 9 (i.e. an object to be stored), which are used when the target object 9 is inserted into or removed from the container 8.

In the present embodiment, the direction in which the target object 9 is removed or inserted through the openings 86 of the container 8 is referred to as an "removal-insertion direction S". The removal-insertion direction S in the present embodiment is a direction extending in the longitudinal direction of the container 8 as viewed in the up-down direction. In the present embodiment, the removal-insertion direction S when the holding device 30 holds the container 8 coincides with the left-right direction Y with respect to the transport apparatus 1.

In the present embodiment, a direction orthogonal to the up-down direction Z and the removal-insertion direction S is referred to as a width direction T. The width direction T is a direction that is parallel to the horizontal direction and orthogonal to the removal-insertion direction S, and in the present embodiment, the width direction T is a direction that is parallel to a transverse direction of the container 8 as viewed in the up-down direction. In the present embodiment, the width direction T when the holding device 30 holds the container 8 coincides with the front-rear direction X with respect to the transport apparatus 1.

The container 8 also includes a held member 84 and slots 88. The held member 84 is a portion to be held by the holding device 30. The held member 84 in the present embodiment is formed as a quadrilateral plate member that is slightly smaller than the top plate 83, and is secured to be slightly spaced above the top plate 83.

The slots 88 are sections where the target object 9 can be placed. The slots 88 in the present embodiment are formed as grooves in the inner surfaces of the pair of side plates 82 along the removal-insertion direction S. The slots 88 are arranged in the up-down direction Z.

The container 8 in the present embodiment is provided with a wireless tag 89. The wireless tag 89 is a tag that can be read and written by wireless communication. In the present embodiment, a passive RFID (Radio Frequency Identification) is used as the wireless tag 89. The wireless tag 89 records unique identification information (an article ID) regarding the container 8 to which the wireless tag 89 is attached. The wireless tag 89 is attached to the upper surface of the bottom plate 81 near an opening 86.

The target object 9 can be placed in any of the plurality of slots 88. The target object 9 includes a tray 91 to be placed in any of the slots 88 and a plurality of articles 92 mounted on the tray 91. The tray 91 corresponds to the shape of the container 8 as viewed in the up-down direction, and is formed in a quadrilateral shape (in this example, a rectangular shape). The tray 91 is housed in the container 8 with both ends in the width direction T placed in the slots 88 at the same height in the pair of side plates 82.

Examples of the articles 92 include semiconductor devices such as IC chips and transistors. The articles 92 are mounted on the tray 91 in a state where, for example, a plurality of articles 92 are aligned in the lengthwise and transverse directions (in the removal-insertion direction S and the width direction T). In the present embodiment, the length in the width direction T and the length in the removal-insertion direction S of each article 92 when the articles 92 are aligned and placed in predetermined initial positions are referred to as a widthwise dimension Wa and a removal-insertion direction dimension Wb, respectively.

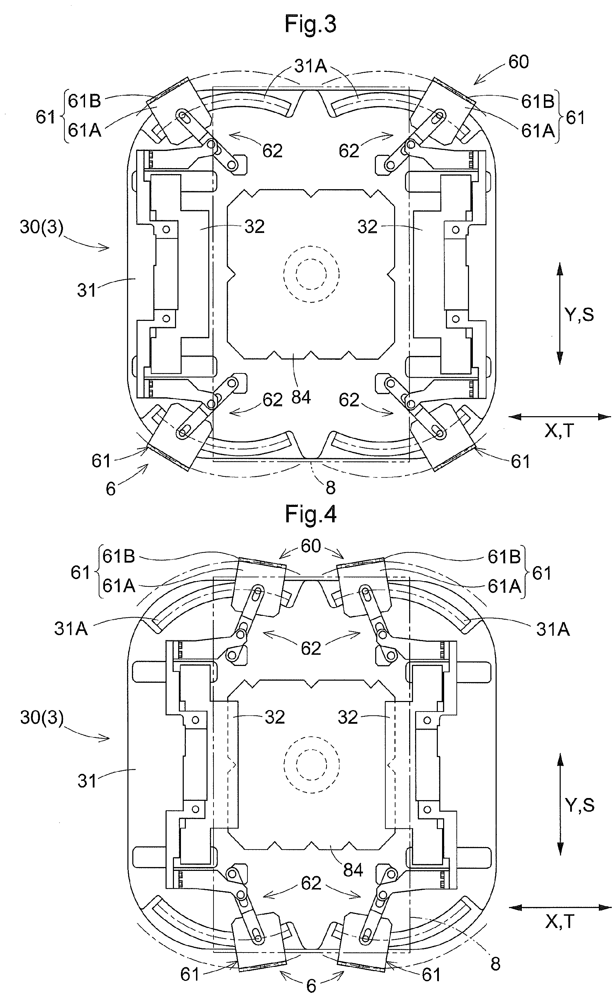

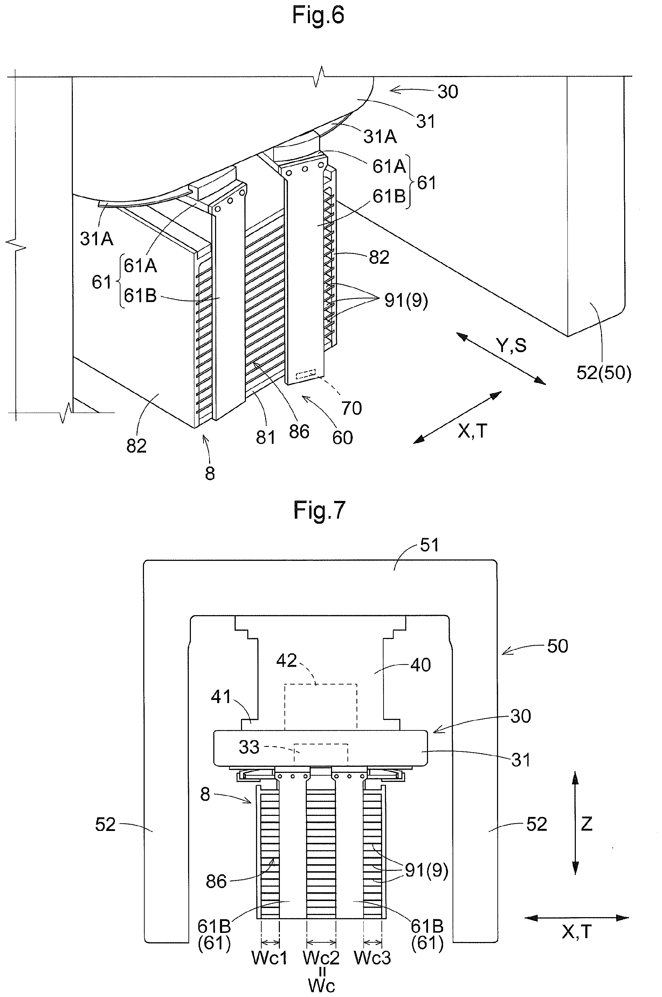

As shown in FIGS. 3 and 4, the holding device 30 includes a holding body 31, holding members 32, and a holding drive device 33 (see FIG. 7). The holding body 31 is a portion that serves as a base of the holding device 30. The holding body 31 holds the holding members 32 in such a manner as to be slidable in the front-rear direction X (the width direction T). The holding body 31 fixedly supports the holding drive device 33.

The holding members 32 hold the held member 84 of the container 8. In the present embodiment, a plurality of holding members 32 are provided in such a manner as to simultaneously support different portions of the held member 84. More specifically, a pair of holding members 32 are provided in such a manner as to simultaneously support portions on opposite sides of the quadrilateral held member 84. The pair of holding members 32 are arranged side by side in the front-rear direction X (width direction T) with a predetermined distance therebetween. The pair of holding members 32 are each configured to be slidable in the front-rear direction X (width direction T), and to move toward or away from each other in the front-rear direction X (width direction T).

The holding drive device 33 moves the pair of holding members 32 in the front-rear direction X (width direction T). The holding drive device 33 includes, for example, a holding electric motor, and a mechanism (for example, a ball screw mechanism) for converting the rotation of the holding electric motor into a propulsive force in the front-rear direction X. The holding drive device 33 moves the pair of holding members 32 in opposite directions so that the pair of holding members 32 move toward each other or away from each other in the front-rear direction X (width direction T).

As the pair of holding members 32 move toward each other in the front-rear direction X (width direction T), the pair of holding members 32 overlap the held member 84 below the held member 84 as viewed in the up-down direction (see FIG. 4). In the present embodiment, this position (i.e. the way in which the pair of holding members 32 are oriented) is referred to as a "holding position", in which the pair of holding members 32 hold the container 8. On the other hand, as the pair of holding members 32 move away from each other in the front-rear direction X (width direction T), the pair of holding members 32 do not overlap the held member 84 as viewed in the up-down direction (see FIG. 3). In the present embodiment, this position is referred to as a "holding release position", in which the pair of holding members 32 release the container 8. The holding drive device 33 changes the position (specifically location and/or orientation) of the pair of holding members 32 to a holding position and a holding release position by moving the pair of holding members 32 toward and away from each other. In the present embodiment, the holding drive device 33 is equivalent to the "drive device".

As shown in FIG. 7, the lifting and lowering device 40 includes a lifting body 41 and a lifting and lowering drive device 42. The lifting body 41 fixedly supports the lifting and lowering drive device 42. The lifting and lowering drive device 42 includes, for example, an electric lifting and lowering motor and a winding unit that rotates integrally with the electric lifting and lowering motor. The winding unit and the holding device 30 are coupled to each other by cords (for example, wires, ropes, or the like). The lifting and lowering device 40 drives the lifting and lowering drive device 42 to wind or unwind the cords, thereby lifting or lowering the holding device 30 between a raised position and a lowered position.

As shown in FIG. 7, the cover member 50 covers the container 8 held by the holding device 30 in the raised position, from above and from sides. The cover member 50 includes a top cover portion 51 and side cover portions 52. The top cover portion 51 covers the container 8 from above. The side cover portion 52 covers the container 8 from above. The side cover portions 52 are provided in a pair in such a manner as to cover the container 8 from both sides in the front-rear direction X (width direction T). The top cover portion 51 and the pair of side cover portions 52 are integrally formed. Note that the cover member 50 is open in the left-right direction Y (removal-insertion direction S). These open sides have the openings 86 of the container 8 held by the holding device 30 in the raised position.

As shown in FIGs. 3 to 7, the transport apparatus 1 (transfer mechanism 3) according to the present embodiment further includes restricting devices 60 in addition to the holding device 30, the lifting and lowering device 40, and the cover member 50. The restricting devices 60 are devices for restricting the stored object 9 from exiting (e.g. jumping out) the container 8 through the openings 86 while the container 8 is held by the holding device 30. The restricting devices 60 each include closing members 61, and the closing members 61 move to a closed position in which the closing members 61 overlap the openings 86 as viewed in the removal-insertion direction (as viewed in the removal-insertion direction S), thereby restricting the stored object 9 from exiting the container 8 through the openings 86.

Note that the closing members 61 can also move to an open position in which the closing members 61 do not overlap the openings 86 as viewed in the removal-insertion direction. Each of the restricting devices 60 is configured so that the closing members 61 move to a closed position and an open position. Note that "position" in an open position and a closed position means the way in which the closing members 61 are oriented.

In the present embodiment, the container 8 has an opening 86 on each side in the removal-insertion direction S, and correspondingly, a restricting device 60 is also provided on each side in the removal-insertion direction S.

As shown in FIGs. 3 and 4, the restricting devices 60 according to the present embodiment each include a pair of closing members 61. On each side with respect to the removal-insertion direction S, a pair of closing members 61 operate in conjunction with each other. In an open position, both closing members 61 are positioned so as not to overlap the opening 86 as viewed in the removal-insertion direction, and in a closed position, both closing members 61 are positioned in such a manner as to overlap the opening 86 as viewed in the removal-insertion direction. In addition, on each side in the removal-insertion direction S, a set of restricting devices 60 operate in conjunction with each other, and the two pairs of (in total four) closing members 61 are configured to simultaneously move to a closed position or an open position.

As can be clearly seen from FIG. 6, each closing member 61 includes a support portion 61A and a plate-shaped portion 61B coupled to the support portion 61A. The support portion 61A is disposed in such a manner as to be slidable along the lower surface of the holding body 31. The plate-shaped portion 61B is formed in a flat plate shape having a predetermined width and extending in the up-down direction Z. The plate-shaped portion 61B extends to a position corresponding to the lowest slot 88. In addition, in the present embodiment, the lower end of the plate-shaped portion 61B extends to the lower end of the container 8 or below in the up-down direction Z. Thus, the plate-shaped portion 61B is disposed in such a manner as to overlap all of the plurality of slots 88 in the closed position as viewed in the removal-insertion direction.

As shown in FIGs. 3 to 5, each restricting device 60 according to the present embodiment includes a link mechanism 62. The link mechanisms 62 link the movement of the holding members 32 with the movement of the closing members 61. More specifically, the closing members 61 change their position in conjunction with the change in position of the holding members 32, and when the holding members 32 move to the holding position, the closing members 61 move to the closed position (FIG. 3→FIG. 4). The closing members 61 change their position in conjunction with the change in position of the holding members 32, and when the holding members 32 move to the holding release position, the closing members 61 move to the open position (FIG. 4→FIG. 3).

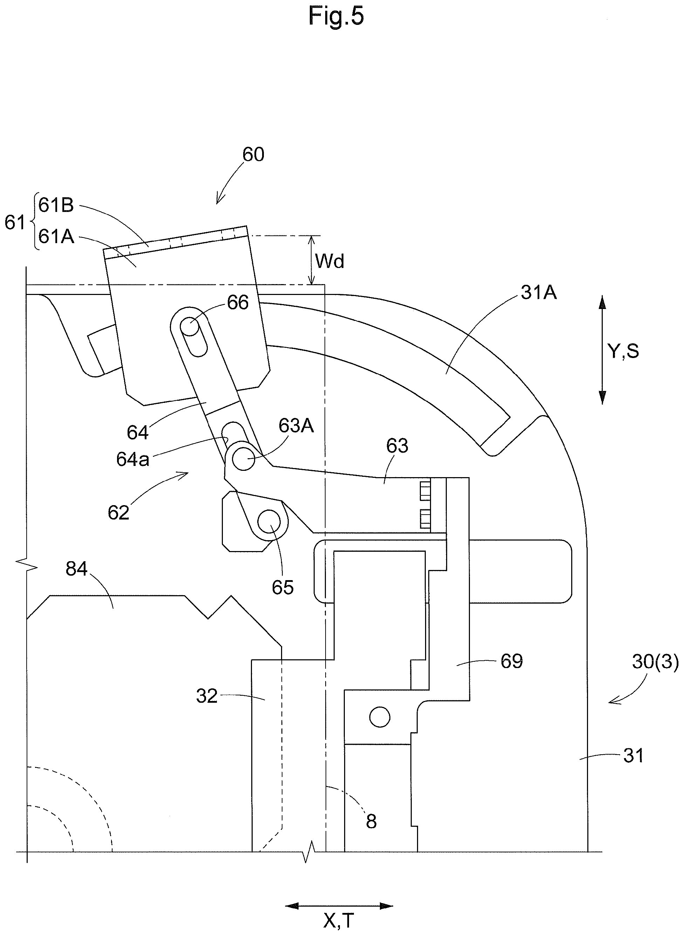

As shown in FIG. 5, each link mechanism 62 includes a drive arm 63 and a driven arm 64 that are coupled to each other in such a manner as to be displaceable relative to each other. The drive arm 63 is fixedly coupled to the holding member 32 of the holding device 30 via a coupling bracket 69. A coupling shaft 63A is provided at the leading end portion of the drive arm 63 (the end portion opposite to the coupling bracket 69). The coupling shaft 63A is inserted into an elongated hole 64a formed in the driven arm 64. The driven arm 64 has one end rotatably coupled to the holding body 31 via a rotation shaft 65, and the other end rotatably coupled to the closing member 61 (support portion 61A) via a support shaft 66.

Note that the rotation shaft 65, the coupling shaft 63A, and the support shaft 66 each have a rotation axis extending in the up-down direction Z. The drive arm 63 and the driven arm 64 are displaceable relative to each other as viewed in the up-down direction.

In the present embodiment, when the holding member 32 slides in the front-rear direction X (width direction T), the drive arm 63 and the coupling shaft 63A correspondingly slide in the front-rear direction X (width direction T). In accordance with this sliding movement, the driven arm 64 pressed by the coupling shaft 63A within the elongated hole 64a rotates about the rotation shaft 65. Then, the closing member 61, which is rotatably supported by the support shaft 66 at the swing end of the driven arm 64, is guided by an arc-shaped slide guide 31A included in the holding body 31, and moves while gradually changing the orientation of the plate-shaped portion 61B.

In this way, the closing member 61 is supported in such a manner as to be pivotable about an imaginary rotation axis located near the rotation shaft 65 and extending in the up-down direction Z. In the present embodiment, the position of this rotation axis is the virtual center position of the arc-shaped slide guide 31A.

In the present embodiment, the coupling shaft 63A and the driven arm 64 are coupled to each other at a position between the rotation shaft 65 and the support shaft 66. Therefore, when a pair of holding members 32 moves toward each other, the plate-shaped portions 61B of a pair of closing members 61 correspondingly pivot toward each other (FIG. 3→FIG. 4). Thus, a pair of closing members 61 assumes the closed position with the plate-shaped portions 61B of the closing members 61 close to each other. On the other hand, when the pair of holding members 32 move away from each other, the plate-shaped portions 61B of a pair of closing members 61 correspondingly pivot away from each other (FIG. 4→FIG. 3). Thus, a pair of closing members 61 assumes the open position with the plate-shaped portions 61B of the closing members 61 spaced apart from each other.

In the closed position, the plate-shaped portions 61B face the openings 86 of the container 8. Here, "the plate-shaped portions 61B face the openings 86 of the container 8" means that the direction orthogonal to the plate surfaces of the plate-shaped portions 61B is oriented toward the openings 86 of the container 8 (in other words, the plate surfaces of the plate-shaped portions 61B are parallel or nearly parallel to the end portions of the container 8 in the removal-insertion direction S). In the present embodiment, the plate-shaped portions 61B are disposed such that, in the closed position, the plate surfaces of the plate-shaped portions 61B extend along the end portions of the container 8 in the removal-insertion direction S toward the outside in the width direction T with an inclination of 5° to 15° (approximately 10° in the illustrated example).

In the present embodiment, as viewed in the removal-insertion direction, the dimension in the width direction T of the region of each opening 86 of the container 8 not covered by the closing members 61 in the closed position (a widthwise dimension Wc of the non-covered region, see FIG. 7) is less than the dimension in the width direction T of the articles 92 (a widthwise dimension Wa, see FIG. 2). Here, in the present embodiment, a pair of closing members 61 cover the corresponding opening 86 of the container 8 at positions spaced apart from each other in the width direction T, and as shown in FIG. 5, there are three regions that are not covered by the closing members 61 in the closed position. Let Wc1, Wc2, and Wc3 be the dimensions in the width direction T of these three regions, respectively. In the present embodiment, let the maximum value among these dimensions be a widthwise dimension Wc of the non-covered region. In this example, the dimension Wc2 in the width direction T between a pair of closing members 61 is the widthwise dimension Wc of the non-covered region.

In addition, in the present embodiment, the gap in the removal-insertion direction S between each closing member 61 in the closed position and the corresponding opening 86 of the container 8 (a removal-insertion direction gap Wd, see FIG. 5) is less than the dimension in the removal-insertion direction S of each article 92 (the removal-insertion direction dimension Wb, see FIG. 2). Here, in the present embodiment, in the closed position, the closing members 61 are disposed such that the plate surfaces of the plate-shaped portions 61B are inclined with respect to the end portions of the container 8 in the removal-insertion direction S. In the present embodiment, the gap in the removal-insertion direction S at the portion of each closing member 61 (the plate-shaped portion 61B) farthest from the corresponding opening 86 of the container 8 is defined as the removal-insertion direction gap Wd.

Note that the articles 92 are simply mounted on the tray 91 and may move and rotate on the tray 91. Therefore, the widthwise dimension Wc of the non-covered region is preferably smaller than whichever of the widthwise dimension Wa or the removal-insertion direction dimension Wb of the articles 92 is shorter (in this example, the removal-insertion direction dimension Wb). Similarly, the removal-insertion direction gap Wd is preferably smaller than whichever of the widthwise dimension Wa or the removal-insertion direction dimension Wb of the articles 92 is shorter (in this example, the removal-insertion direction dimension Wb). In short, it is preferable that the widthwise dimension Wc of the non-covered region and the removal-insertion direction gap Wd are smaller than the minimum width dimension between two opposite surfaces of each article 92 as viewed in the up-down direction.

As shown in FIG. 6, a wireless tag reader 70 is attached to one closing member 61 of the pair of closing members 61 on one side in the left-right direction Y (removal-insertion direction S). The wireless tag reader 70 is attached to the surface on the container 8 side of one plate-shaped portion 61B of the pair of plate-shaped portions 61B near the lower end thereof. The pair of closing members 61, when in the closed position, come close to the wireless tag 89 (see FIG. 2) attached to the bottom plate 81 of the container 8. Then, in the closed position, the wireless tag reader 70 reads the wireless tag 89 attached to the bottom plate 81. In the present embodiment, the wireless tag reader 70 is an antenna that reads an RFID tag, which is the wireless tag 89.

From the viewpoint of allowing the wireless tag reader 70 to properly read the wireless tag 89, the plate-shaped portions 61B are preferably made of a non-metallic material. The plate-shaped portions 61B may be made of, for example, a resin material.

Hereinafter, other embodiments of the present invention will be described.

The above embodiment describes, as an example, a configuration in which each holding device 30 includes a pair of holding members 32 that are slidable in the front-rear direction X (width direction T). However, the present invention is not limited to such a configuration, and each holding device 30 may include three or more holding members 32. The three or more holding members 32 may hold the held member 84 by, for example, sliding radially around the held member 84.

The above embodiment describes, as an example, a configuration in which each holding device 30 holds the container 8 by moving the pair of holding members 32 toward each other, and to release the container 8 by moving the pair of holding members 32 away from each other. However, the present invention is not limited to such a configuration, each holding device 30 may be configured to hold the container 8 by moving the pair of holding members 32 away from each other, and to release the container 8 by moving the pair of holding members 32 toward each other. In this case, it is preferable that each pair of closing members 61 is configured to move to the closed position in conjunction with the pair of holding members 32 moving away from each other, and to move to the open position in conjunction with the pair of holding members 32 moving toward each other. Such a configuration can be realized, for example, by disposing the connection between the coupling shaft 63A and the driven arm 64 on the opposite side of the support shaft 66 with respect to the rotation shaft 65.

The above embodiment describes an example in which each holding device 30 is configured as a chuck type. However, the present embodiment is not limited to such a configuration, and the specific configuration of each holding device 30 may be of any type as long as it can at least hold the container 8, and each holding device 30 may be configured as a fork type, for example.

The above embodiment describes, as an example, a configuration in which each restricting device 60 includes a pair of closing members 61. However, the present invention is not limited to such a configuration, and each restricting device 60 may include a single closing member 61 or three or more closing members 61. The number of closing members 61 is preferably equal to or less than the number of holding members 32.

The above embodiment describes an example in which each link mechanism 62 includes the rotation shaft 65, the drive arm 63, the coupling shaft 63A, the driven arm 64, and the support shaft 66. However, the present invention is not limited to such a configuration, and the specific configuration of each link mechanism 62 may be of any type as long as it can convert the linear motion of the pair of holding members 32 into the pivoting motion of the pair of closing members 61.

The above embodiment describes, as an example, a configuration in which the movement of the holding members 32 and the movement of the closing members 61 are linked by the link mechanisms 62. However, the present invention is not limited to such a configuration, and the movement of the holding members 32 and the movement the closing members 61 may be linked by another mechanism, such as a gear mechanism or a pulley mechanism.

The above embodiment describes, as an example, a configuration in which each pair of closing members 61 changes its position by pivoting. However, the present invention is not limited to such a configuration, and for example, each pair of closing members 61 may change its position by linear movement in the front-rear direction X (width direction T).

The above embodiment describes, as an example, a configuration in which the widthwise dimension Wc of the non-covered region of each opening 86 of the container 8, which is not covered by the closing members 61 in the closed position, is smaller than the widthwise dimension Wa of the articles 92. However, the present invention is not limited to such a configuration, and the widthwise dimension Wc of the non-covered region may be slightly greater than the widthwise dimension Wa of the articles 92. The widthwise dimension Wc of the non-covered region may be greater than the widthwise dimension Wa of the articles 92 and less than the diagonal dimension of the articles 92.

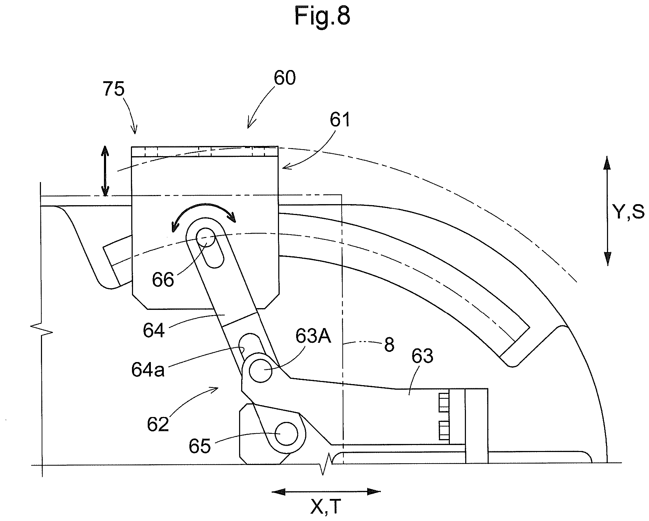

The above embodiment describes, as an example, a configuration in which the closing members 61 (the plate-shaped portions 61B) in the closed position are disposed inclined with respect to the end portions of the container 8 in the removal-insertion direction S. However, the present invention is not limited to such a configuration, and the closing members 61 (the plate-shaped portions 61B) in the closed position may be disposed parallel to the end portions of the container 8 in the removal-insertion direction S. In this case, the closing members 61 (the plate-shaped portions 61B) may be disposed in such a manner as to abut against the container 8 without being spaced apart from the container 8 in the removal-insertion direction S. Such a configuration may be structurally set so that such an arrangement is realized in the closed position, or it may be adjustable afterwards. In the latter case, for example, as shown in FIG. 8, adjustment mechanisms 75 may be provided, each of which can change the angle of the corresponding plate-shaped portion 61B in the closed position as viewed in the up-down direction and the position of the plate-shaped portion 61B in the removal-insertion direction S. Each adjustment mechanism 75 may be capable of changing only the angle of the plate-shaped portion 61B, or may be capable of changing only the position of the plate-shaped portion 61B. Alternatively, each adjustment mechanism 75 may be further capable of changing, for example, the position of the plate-shaped portion 61B in the up-down direction Z.

The above embodiment provides a description mainly assuming that the plate-shaped portions 61B made of a resin material are used without change. However, the present invention is not limited to such a configuration, and for example, plate-shaped portions 61B that have been subjected to a surface treatment may be used. Examples of the surface treatment include anti-slip treatment by coating treatment, roughening treatment, or the like, and antistatic treatment by coating treatment or the like.

The above embodiment describes, as an example, a configuration in which the wireless tag reader 70 is attached to a closing member 61 (a plate-shaped portion 61B). However, the present invention is not limited to such a configuration, and, for example, the wireless tag reader 70 may be mounted on the cover member 50 (a side cover portion 52) in such a manner as to be able to extend to and retract from the position of the wireless tag 89 attached to the container 8.

The above embodiment describes, as an example, a configuration in which the object 9 stored in the container 8 includes the tray 91 and a plurality of articles 92 mounted thereon. However, the present invention is not limited to such a configuration, and, for example, the target object 9 may be any object that can be stored in the container 8, such as a semiconductor substrate or a semiconductor wafer.

The above embodiment describes, as an example, a configuration in which the transport apparatus 1 is an overhead transport vehicle. However, the present invention is not limited to such a configuration, and the transport apparatus 1 may be an apparatus that travels on the floor surface, such as an unmanned transport vehicle or an autonomous transport robot.

The configurations disclosed in the above embodiments (including the above embodiment and other embodiments; the same applies below) may be applied in combination with configurations disclosed in other embodiments as long as no contradiction arises. As for other configurations, the embodiments disclosed in the present specification are illustrative in all respects and can be appropriately modified within the scope of the present disclosure.

To summarize the above, the transport apparatus according to the present invention preferably includes the following configurations.

A transport apparatus for transporting a container having an opening in a side surface thereof through which a target object is removed or inserted, the transport apparatus including: a holding device including a plurality of holding members and a drive device configured to move the plurality of holding members to a holding position for holding the container and a holding release position for releasing the container; and a restricting device configured to restrict the target object from exiting the container through the opening while the container is held by the holding device, the restricting device including at least one closing member movable to a closed position, in which the at least one closing member overlaps the opening as viewed in a removal-insertion direction in which the target object is inserted into and removed from the container through the opening, and an open position, in which the at least one closing member does not overlap the opening as viewed in the removal-insertion direction, the at least one closing member being movable in conjunction with the movement of the holding members such that the at least one closing member moves to the closed position in accordance with the holding members moving to the holding position, and the at least one closing member moves to the open position in accordance with the holding members moving to the holding release position.

With this configuration, it is possible to prevent the target object from exiting the container through the opening by setting the closing member of the restricting device to the closed position during transport. In addition, the movement of the closing member to the closed position and the open position is linked with the movement of the holding members to the holding position and the holding release position, and therefore there is no need to provide a dedicated drive mechanism for changing the position of the closing member. Therefore, it is possible to downsize and simplify the apparatus.

In one aspect, it is preferable that the container includes a plurality of slots arranged in an up-down direction, the target object includes a tray placeable in any of the slots and a plurality of articles mounted on the tray, and a region of the opening which region the at least one closing member does not cover in the closed position has, as viewed in the removal-insertion direction, a smaller dimension in a width direction orthogonal to the up-down direction and the removal-insertion direction than a dimension of the articles in the width direction.

With this configuration, when the closing member is in the closed position, the target object can be effectively prevented from exiting the container through the opening.

In one aspect, it is preferable that the container includes a plurality of slots arranged in an up-down direction, the target object is placeable in any of the plurality of slots, and the at least one closing member includes a plate-shaped portion disposed in such a manner as to overlap all of the plurality of slots as viewed in the removal-insertion direction and face the opening in the closed position.

With this configuration, the plate-shaped portion overlaps all of the plurality of slots in the closed position as viewed in the removal-insertion direction, and therefore the entire target object can be appropriately prevented from exiting. The plate-shaped portion is disposed in such a manner as to face the opening of the container in the closed position, and therefore the plate-shaped portion can cover a relatively wide area of the opening, and can effectively prevent the target object from exiting.

In one aspect, it is preferable that the at least one closing member includes a pair of closing members, the pair of closing members are each supported in such a manner as to be pivotable about a rotation axis extending in the up-down direction, and the pair of closing members moves to the closed position in accordance with the respective plate-shaped portions of the pair of closing members pivoting toward each other, and moves to the open position in accordance with the respective plate-shaped portions of the pair of closing members pivoting away from each other.

With this configuration, it is possible to simplify the restricting device including a pair of closing member that move to the closed position and the open position.

In one aspect, it is preferable that the plurality of holding members include a pair of holding members, and the drive device is configured to move the pair of holding members toward each other into the holding position and away from each other into the holding release position, and the restricting device includes a link mechanism configured to link the pair of holding members and the pair of closing members with each other such that the respective plate-shaped portions of the pair of closing members pivot away from each other in conjunction with the pair of holding members moving away from each other, and the respective plate-shaped portions of the pair of closing members pivot toward each other in conjunction with the pair of holding members moving toward each other.

With this configuration, the link mechanism converts linear motion of the pair of holding members moving toward or away from each other into pivoting motion of the pair of closing members. Therefore, it is possible to realize a mechanism for linking the motion of the pair of closing members to the closed position and the open position with the motion of the pair of holding members to the holding position and the holding release position, with a relatively simple configuration.

In one aspect, it is preferable that the restricting device includes an adjustment mechanism configured to change at least an angle of the plate-shaped portion in the closed position as viewed in the up-down direction or a position of the plate-shaped portion in the removal-insertion direction in the closed position.

With this configuration, it is possible to adjust at least the angle or position of the plate shaped portion depending on the size, shape, or the like of the container to be actually transported. Therefore, the range of the opening covered by the plate-shaped portion and the distance in the removal-insertion direction between the container and the plate-shaped portion can be adjusted, and the target object can be appropriately prevented from exiting regardless of the size, shape, or the like of the container.

In one aspect, it is preferable that the closing member is provided with a wireless tag reader configured to read a wireless tag provided on the container.

With this configuration, when the closing member is in the closed position in which the closing member is close to the container and covers the opening of the container, the wireless tag reader provided on the closing member can read the wireless tag provided on the container. Therefore, it is possible to check during transportation whether or not the container actually transported is the intended container.

The transport apparatus according to the present invention need only achieve at least one of the above-described effects.

### REFERENCE SIGNS

- 1: Transport Apparatus
- 2: Travel Unit
- 3: Transfer Mechanism
- 8: Container
- 9: Target Object
- 21: Body
- 22: Travel Device
- 23: Wheel
- 24: Guide Wheel
- 30: Holding Device
- 31: Holding Body
- 31A: Arc-shaped Slide Guide
- 32: Holding Member
- 33: Holding Drive Device (Drive Device)
- 40: Lowering Device
- 41: Lifting Body
- 42: Lowering Drive Device
- 50: Cover Member
- 51: Top Cover Portion
- 52: Side Cover Portion
- 60: Restricting Device
- 61: Closing Member
- 61A: Support Portion
- 61B: Plate-shaped Portion
- 62: Link Mechanism
- 63: Drive Arm
- 63A: Coupling Shaft
- 64: Driven Arm
- 64a: Elongated Hole
- 65: Rotation Shaft
- 66: Support Shaft
- 69: Coupling Bracket
- 70: Wireless Tag Reader
- 75: Adjustment Mechanism
- 81: Bottom Plate
- 82: Side Plate
- 83: Top Plate
- 84: Held Member
- 86: Opening
- 88: Slot
- 89: Wireless Tag
- 91: Tray
- 92: Article
- 98: Ceiling
- 99: Rail

- X: Front-rear Direction
- Y: Left-right Direction
- Z: Up-down Direction
- S: Insertion and Removal Direction
- T: Width Direction
- Wa: Widthwise Dimension of Article
- Wb: Removal-insertion Direction Dimension of Article
- Wc: Widthwise Direction of Non-covered Region
- Wc1, Wc2, Wc3: Dimensions in the Width Direction T
- Wd: Removal-insertion Direction Gap

## Claims

1. A transport apparatus (1) for transporting a container (8) having an opening (86) in a side surface thereof through which a target object (9) is removed or inserted, the transport apparatus (1) comprising:
a holding device (30) including a plurality of holding members (32) and a drive device (33) configured to move the plurality of holding members (32) to a holding position for holding the container (8) and a holding release position for releasing the container (8); and
a restricting device (60) configured to restrict the target object (9) from exiting the container (8) through the opening (86) while the container (8) is held by the holding device (30),
the restricting device (60) including at least one closing member (61) movable to a closed position, in which the at least one closing member (61) overlaps the opening (86) as viewed in a removal-insertion direction (S) in which the target object (9) is inserted into and removed from the container (8) through the opening (86), and an open position, in which the at least one closing member (61) does not overlap the opening (86) as viewed in the removal-insertion direction (S), the at least one closing member (61) being movable in conjunction with the movement of the holding members (32) such that the at least one closing member (61) moves to the closed position in accordance with the holding members (32) moving to the holding position, and the at least one closing member (61) moves to the open position in accordance with the holding members (32) moving to the holding release position.

2. The transport apparatus (1) according to claim 1, wherein
the container (8) includes a plurality of slots (88) arranged in an up-down direction (Z),
the target object (9) includes a tray (91) placeable in any of the slots (88) and a plurality of articles (92) mounted on the tray (91), and a region of the opening (86), which region the at least one closing member (61) does not cover in the closed position has, as viewed in the removal-insertion direction (S), a smaller dimension (Wc) in a width direction (T) orthogonal to the up-down direction (Z) and the removal-insertion direction (S) than a dimension (Wa) of the articles (92) in the width direction (T).

3. The transport apparatus (1) according to claim 1 or 2, wherein
the container (8) includes a plurality of slots (88) arranged in an up-down direction (Z),
the target object (9) is placeable in any of the plurality of slots (88), and
the at least one closing member (61) includes a plate-shaped portion (61B) disposed in such a manner as to overlap all of the plurality of slots (88) as viewed in the removal-insertion direction (S) and face the opening (86) in the closed position.

4. The transport apparatus (1) according to claim 3,wherein
the at least one closing member (61) includes a pair of closing members (61),
the pair of closing members (61) are each supported in such a manner as to be pivotable about a rotation axis extending in the up-down direction (Z), and
the pair of closing members (61) moves to the closed position in accordance with the respective plate-shaped portions (61B) of the pair of closing members (61) pivoting toward each other, and moves to the open position in accordance with the respective plate-shaped portions (61B) of the pair of closing members (61) pivoting away from each other.

5. The transport apparatus (1) according to claim 4, wherein
the plurality of holding members (32) include a pair of holding members (32), and the drive device (33) is configured to move the pair of holding members (32) toward each other into the holding position and away from each other into the holding release position, and
the restricting device (60) includes a link mechanism (62) configured to link the pair of holding members (32) and the pair of closing members (61) with each other such that the respective plate-shaped portions (61B) of the pair of closing members (61) pivot away from each other in conjunction with the pair of holding members (32) moving away from each other, and the respective plate-shaped portions (61B) of the pair of closing members (61) pivot toward each other in conjunction with the pair of holding members (32) moving toward each other.

6. The transport apparatus (1) according to claim 3, wherein
the restricting device (60) includes an adjustment mechanism (75) configured to change at least an angle of the plate-shaped portion (61B) in the closed position as viewed in the up-down direction (Z) or a position of the plate-shaped portion (61B) in the removal-insertion direction (S) in the closed position.

7. The transport apparatus (1) according to any one of claims 1 to 6, wherein the closing member (61) is provided with a wireless tag reader (70) configured to read a wireless tag (89) provided on the container (8).
